# EUROPEAN PATENT APPLICATION

(11) **EP 4 719 009 A1**
(43) Date of publication of application: **01.04.2026**
(21) Application number: 25204982.0
(22) Date of filing: 26.09.2025
(51) Int. Cl.: H10H 20/819, H10H 20/841, H10H 29/10, H10H 29/80

(54) **MICROLEDS EMITTING LAMBERTIAN RADIATION PATTERNS**

(30) Priority: 26.09.2024 US 202418897311
(71) Applicant: Lumileds Singapore Pte. Ltd., Singapore 768925 (SG)
(72) Inventor: DiMaria, Jeff, San Jose, 95131 (US); Ren, Zhongmin, San Jose, 95131 (US); Lopez-Julia, Antonio, 52068 Aachen (DE); Shen, Yu-Chen, San Jose, 95131 (US)
(74) Representative: dompatent

(57) **Abstract**

An LED light source to produce a more Lambertian radiation pattern having a microLED die where the side walls of the die are reflective and sloped at a greater than 20 degrees angle and where the top surface of the LED die is roughened. Scattering particles may also be placed on the top emitting surface of the microLED. An optical element with roughened surfaces may be placed above the microLED die. The microLED die may also be placed in a cup structure with reflective side walls.

## Description

### FIELD OF THE INVENTION

The invention relates generally to microLED light sources.

### BACKGROUND

Semiconductor light emitting diodes ("LEDs") are among the most efficient light sources currently available. The emission spectrum of a LED typically exhibits a single narrow peak at a wavelength determined by the structure of the device and by the composition of the semiconductor materials from which it was constructed. Conventional LEDs have large planar emission areas where most of the light is emitted through the top surface of the LED. But microLEDs are five-sided light emitters with non-trivial amounts of light being emitted from the side of the LED.

The side emission of light from microLED is undesirable in certain applications such as direct view displays which prefer a Lambertian-like radiation pattern. A Lambertian radiating pattern occurs when the radiance of the light source is independent of the angle from which the light source is viewed.

### SUMMARY

This application discloses a microLED light source with a more Lambertian radiation pattern that is more suitable for direct view displays than microLEDs currently available. In one embodiment, such a light source includes a microLED thin-film flip-chip (TFFC) die. In one embodiment, the light source includes a microLED having a less than 30 micron thick sapphire layer. In one embodiment, the dimensions of the microLED die are less than 20 microns: e.g. a length less than 20 microns, a width less than 20 microns, and a thickness less than 20 microns. The microLED die has an n contact and a p contact on the same side of the microLED die. In one embodiment, the microLED die has several semiconductor layers including a n-doped layer, a p-doped layer, an active region, and a current spreading layer. In one embodiment, has several semiconductor layers including two or more n-doped layers, two or more p-doped layers, two or more active regions, one or more tunnel junctions, and a current spreading layer. Each of these layers has a sloped side wall. The sloped side walls are angled at greater than 20 degrees angle with respect to a perpendicular to the bottom surface of the die. In one embodiment, the side walls are angled at about 45 degrees with respect to a perpendicular to the bottom surface of the die. In one embodiment, the current spreading layer side walls are angled at a different angle than the side walls of the other layers are angled at.

The side walls of the semiconductor layers are coated with a reflective optical side coat. The reflective optical side coat is coated onto the side walls of the semiconductor layers making a conformal coating. The reflective side coat eliminates or greatly reduces light emitted from the sides of the microLED leading to a more Lambertian radiation pattern. The reflective optical coat may also coat the bottom semiconductor surface of the microLED die.

In one embodiment, the reflective optical side coat includes a dielectric layer and a metal layer. The dielectric layer may be a material with a low index of refraction such as silica or silicon dioxide (SiO₂), magnesium fluoride (MgF₂), or silicon nitride. The metal layer may include silver or gold. The interface between the dielectric layer and the metal layer has a critical angle that allows for total internal reflection at the interface.

In one embodiment, the reflective optical side coat includes a distributed Bragg reflector (DBR), which consists of an alternating sequence of layers of two different optical materials with different refractive indices. When the reflective side coat includes a DBR, an additional metal layer may or may not be used. If the reflective optical coat includes a metal layer, an additional dielectric layer coating the metal layer may be included.

In one embodiment, the reflective optical side coat may include scattering particles dispersed in a matrix material. For example, the optical side coat may be titanium oxide (TiOx) particles dispersed in a silicone matrix. The percentage of scattering particles in the optical coat is high enough to scatter all or substantially all light emitted from the side of the microLED back into the semiconductor layers of the microLED.

In one embodiment, the top surface of the microLED die is roughened to randomize the light emitted from the top surface, which leads to a more Lambertian radiation pattern. In one embodiment, the top surface of the current spreading layer is roughened.

In one embodiment, all side walls of the n-doped and p-doped semiconductor layers are covered with the reflective optical side coat. In one embodiment, one side wall of the current spreading layer is not covered with the reflective optical side coat. For example, in a rectangularly shaped microLED, three of the side walls of the current spreading layers may be covered with reflective optical side coat and one side wall is not covered. In an alternative embodiment, all side walls of the current spreading layer are covered with reflective optical side coat.

In one embodiment, the light source comprises scattering particles placed on the top surface of the microLED die, e.g. on the top surface of the current spreading layer. Several thin-film layers are used to cement the scattering particles in place. The scattering particles may be TiOx particles. The scattering particles may be several layers thick on the top surface of the microLED. The thin-film layers may be transparent and may be deposited onto the scattering particles by chemical vapor deposition (CVD) or by atomic layer deposition (ALD) to cement the particles in place. The scattering particles randomly scatter light emitted by the microLED die leading to a more Lambertian radiation pattern.

In one embodiment, an optical element is placed above the top surface of the microLED. The optical element is held above the microLED by a hollow pedestal. The inner side walls of the pedestal, the top surface of the microLED, and the bottom surface of the optical element define an internal cavity that may be filled with air. The optical element may be composed of glass, silicone, or a transparent material. The top and bottom surfaces of the optical element may be roughened. In one embodiment, the top and bottom surfaces of the optical element may be coated with an antireflective coating. In one embodiment, the inner side walls of the pedestal may be coated with reflective material, such as silver or gold. In one embodiment, the inner side walls of the pedestal may comprise a distributed Bragg reflector. In one embodiment, the top or bottom surface is or both surfaces are curved to form a lens.

In one embodiment, the light source comprises a microLED mounted on the bottom surface of and in the interior of a cup structure. The cup is filled with a fill material, which may be silicone. The fill material may cover the sides of the microLED, but not the top surface of the microLED. In one embodiment, the inner surface of the side walls of the cup are covered by a reflective metal. In one embodiment, the side walls of the cup comprise a distributed Bragg reflector. In one embodiment, the inner surface of the side walls of the cup are roughened to randomize the direction of light reflected off the inner surface of the side walls of the cup. In one embodiment, the fill material may include a small percentage of scattering particles, such as TiOx particles. In one embodiment, the fill material may include a high percentage of scattering particles.

These and other embodiments, features and advantages of the present invention will become more apparent to those skilled in the art when taken with reference to the following more detailed description of the invention in conjunction with the accompanying drawings that are first briefly described.

### BRIEF DESCRIPTION OF THE DRAWINGS

FIG. 1 schematically illustrates a cross-sectional view of a microLED die.
FIG. 2 schematically illustrates a cross-sectional view of a microLED die with scattering particles.
FIG. 3 schematically illustrates a cross-sectional view of a microLED die with a transparent cover.
FIG. 4 schematically illustrates a cross-sectional view of a microLED die in a cup structure.
FIG. 5 schematically illustrates a cross-sectional view of a semiconductor structure with multiple active regions.
FIG. 6 schematically illustrates a cross-sectional view of a semiconductor structure with multiple active regions.
FIG. 7 schematically illustrates a cross-sectional view of a semiconductor structure with multiple active regions.
FIG. 8 schematically illustrates a cross-sectional view of a semiconductor structure with multiple active regions.
FIG. 9 schematically illustrates a cross-sectional view of a microLED die in a cup structure.
FIG. 10 illustrates angular far-field radiation of microscale patterned sapphire substrate (microPSS) features and nanoscale patterned sapphire substrate (nanoPSS) features of a microLED.

### DETAILED DESCRIPTION

The following detailed description should be read with reference to the drawings, in which identical reference numbers refer to like elements throughout the different figures. The drawings are not to scale, depict selective embodiments, and are not intended to limit the scope of the invention. The detailed description illustrates by way of example, not by way of limitation, the principles of the invention.

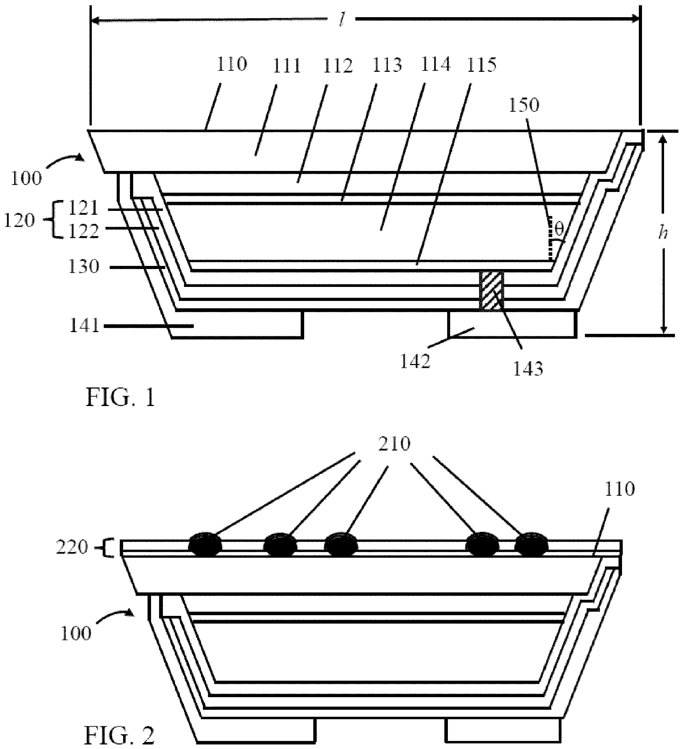

FIG. 1 shows a schematic cross-sectional view of an example microLED die 100. For example, the dimensions of the microLED are less than 20 microns. For example, the thickness or height *h* of the die (see FIG. 1) may be less than 5 microns. The length, *l,* and width (not shown) of the microLED may be less than 10 microns. Die 100 is a thin-film flip-chip (TFFC) microLED die where the sapphire growth substrate has been removed and p contact 142 and n contact 141 are at the bottom of the die. In some embodiments, die 100 may be a flip-clip die with a thin layer of sapphire on the top of the die, e.g. the die may be manufactured like a TFFC die except the sapphire substrate is not completely removed. This thin layer of sapphire is less than 30 microns thick. Die 100 includes semiconductor layer 112 which is n doped, semiconductor layer 114 which is p doped, and multi-quantum well (MQW) active region 113 between the n doped and p doped layers. Die 100 further includes semiconductor layer 111 which functions as a current spreading layer. Semiconductor layer 111 may be n doped.

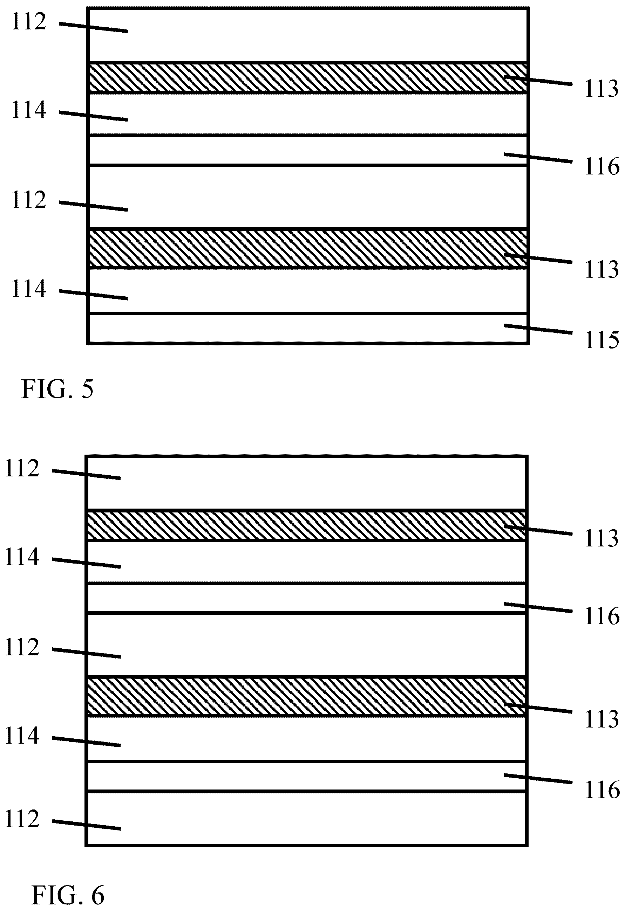

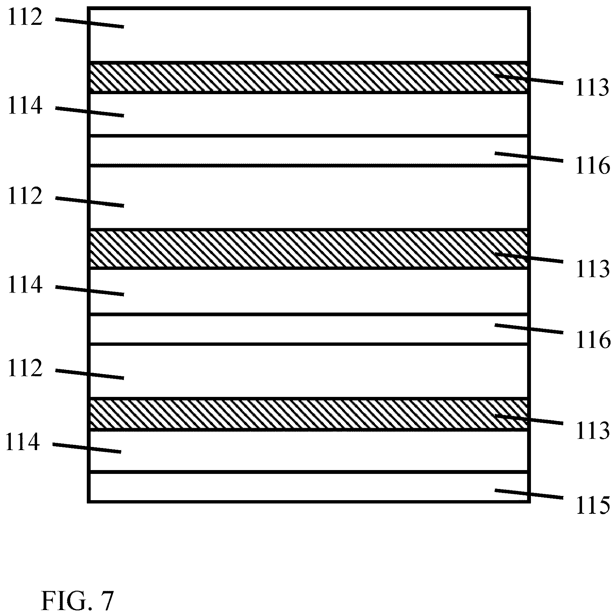

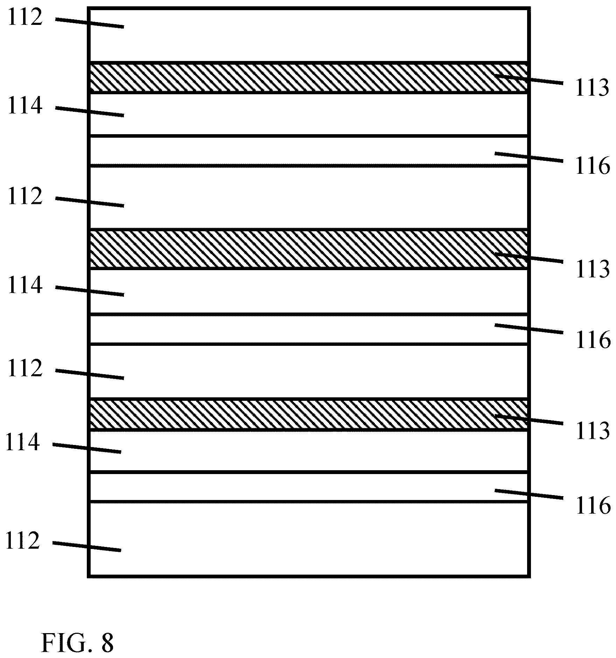

In some embodiments, the microLED die includes multiple active regions separated by tunnel junctions. Tunnel junctions allow current flow, e.g. two-way tunneling of electrons and holes, through a very thin depletion region. This is achieved by suitable heavy doping to create the tunnel junction. For example, a microLED die may have two MQW active regions that are separated by one or more tunnel junctions, such as shown in FIGS. 5 and 6. Other configurations are possible, such as a microLED die with three MQW active regions separated by one or more tunnel junctions, such as shown in FIGS. 7 and 8. As FIGS. 5-8 show, a die with more than one MQW active region separated by one or more tunnel junctions may include more than one n-doped semiconductor layer and more than one p-doped semiconductor layer.

FIGS. 5-8 illustrate the semiconductor layer stack independent of the rest of the light emitting device, for ease of understanding. The semiconductor layer stack shown in FIGS. 5-8 may be substituted for the semiconductor stacks shown in any of FIGS.1-4, (e.g., a stack of any of layers 111, 112, 113, 114, 115 taken together). For example, the stack shown in FIG. 6 may be substituted for layers 112, 113, 114, and 115 shown in FIG. 1 so that the topmost semiconductor layer 112 of FIG. 6 is in direct contact with semiconductor layer 111 of FIG. 1 and the bottommost semiconductor layer 112 of FIG. 6 is in direct contact with dielectric layer 112 of FIG. 1.

FIG. 5 includes two MQW active regions 113 each bounded by and in direct contact with a n-doped semiconductor layer 112 and a p-doped semiconductor layer 114, stacked on top of each other with a tunnel junction 116 in between. The tunnel junction may be in direct contact with a p-doped semiconductor layer 114 and n-doped semiconductor layer 112. At the bottom of the stack is a transparent conductive oxide (TCO) layer 115. FIG. 6 shows a similar stack to FIG. 5, except that instead of bottom TCO layer 115 there is a second tunnel junction 116 and a n-doped semiconductor layer 112. FIG. 7 depicts a stack with three MQW active regions 113 and three pairs of n-doped semiconductor layers 112 and p-doped semiconductor layers 114, with two tunnel junctions 116 in between them, and a bottom TCO layer 116. FIG. 8 shows a similar stack to FIG. 7, except that instead of bottom TCO layer 115 there is a third tunnel junction 116 and a n-doped semiconductor layer 112. If the stack is terminated with n-doped semiconductor layer 112 on each end as in some of the embodiments described above, the necessity of a TCO may practically be eliminated (unlike p-type, n-type semiconductor can be grown to be a good electrical spreading layer). The stacked tunnel junctions with multiple active regions enable higher power density as described in the following equation: Light output = Nj*Vf*If*EQE*EE, with Nj: number of active regions, Vf: forward voltage of one active region, EQE: External quantum efficiency of device, EE: Electrical efficiency of one active region. Equation assumes all active regions are identical, but they may not need to be, in which case the equation may be adjusted.

A microLED die with multiple MQW active regions separated by one or more tunnel junctions has increased light emission. Greater light emission of the multiple-active-regions die results in greater side emission of light from die, which may be disadvantageous for certain applications, as discussed above, but may be improved with the techniques discussed below

To achieve a more Lambertian-like radiation pattern, the side walls of die 100 are sloped and a reflective side coat is added to the side walls. Specifically, the four side walls of semiconductor layers of the die are sloped. For example, in FIG. 1 semiconductor layers 111, 112, 113, and 114 are sloped. Only two of the side walls of each semiconductor layer are illustrated in FIG. 1. The two other side walls not shown are in and out of the plane of the cross-section shown in FIG. 1. For dies with multiple active regions and tunnel junctions, the semiconductor layers associated with those active regions and tunnel junctions are similarly sloped. The side walls of the semiconductor layers are sloped away from perpendicular line 150 at angle θ as shown in FIG. 1, where line 150 is perpendicular to the bottom surface of the semiconductor layer. Further, all four side walls of semiconductor layers 111, 112, and 114 are sloped in a similar manner. In some embodiments, angle θ for current spreading layer 111 may be different than for the rest of the die.

The sloped side walls of semiconductor layers 111, 112, and 114 and the bottom surface of semiconductor layer 114 are coated with an optical side coat 120. In the example of FIG. 1, the optical side coat includes dielectric layer 121 composed of a material with low refractive index, such as silicon dioxide, and metal layer 122 made from silver or gold. In the example of FIG. 1, an additional dielectric layer 130 is needed to cover metal layer 122 to prevent electrical shorts, for example, between the n and p contacts. Optical side coat 120 reflects light emitted from the side of the die. Due to the angle θ at which the side walls are sloped, light reflected by optical side coat 120 is redirected towards the top surface 110 of the microLED die. To achieve a Lambertian-like radiation pattern, the inventors have discovered that angle θ must be greater than 20 degrees. In the most preferred embodiment, angle θ is about 45 degrees. Top surface 110 is roughened to randomize light emission and achieve a more Lambertian radiation pattern.

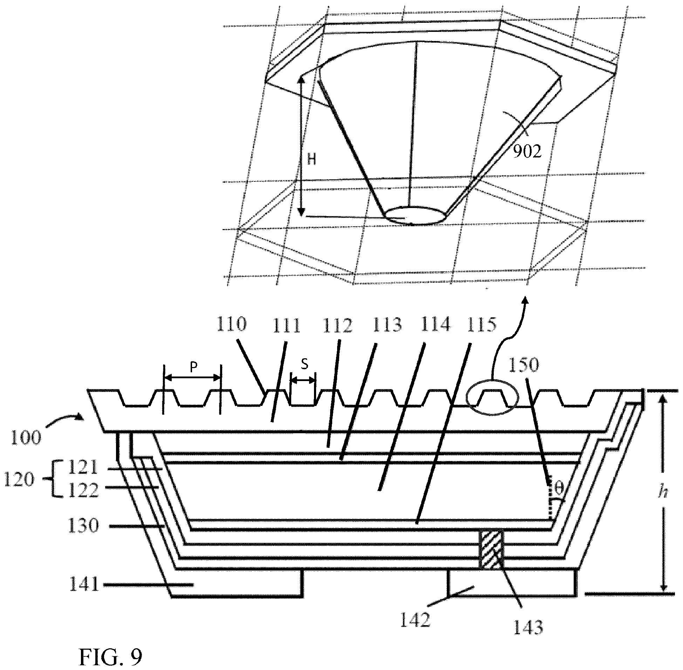

Alternatively or additionally, top surface 110 may be nano-scale patterned to transmit light with a narrow angular distribution that is on-axis centered. This is shown in FIG. 9. Typical nanoscale features may include periodic shapes forming a regular pattern and having any of the following characteristics: a hexagonal lattice (based on the sapphire lattice structure), about 200 nm to about 500 nm pitch (P), about 200 nm to about 500 nm height (H), and about 20% spacing (S) (i.e., of the pitch). Other shapes are possible as long as dimensions are kept within a few hundred nanometers. As shown in the inset of Fig. 9, the shape 902 used in the pattern of top surface 110 may be substantially frustoconical. One optimal pitch of the nanoPSS features is about 350nm to about 400nm for steep trench angles (about 5° or less) - which gives rise to the largest light extraction efficiency (ExE) in this angular range with a moderately high simulated forward emission. There may also be a tradeoff between the forward emission and ExE. For oblique trench angles, a small pitch/size may be preferred. An optimal pitch for ExE (regardless of the trench angle) may be less than about 400 nm. The size dependence on trench angle may be that an optimal pitch may reduce with increasing trench angle. These nano-scale features may be obtained by, for example, nanolithography, or by growing epi on nanoscale patterned sapphire substrate (nanoPSS). After laser lift off (LLO) the exposed nano-scale features on the GaN surface can efficiently steer the angular emission forward. LEDs with nanoPSS features can outperform LEDs with planar epitaxy for a 45° cone emission with trench sidewall angles of less than about 8°. For about a 5° trench angle (with respect to a normal angle from the emission surface), a 6% total flux improvement and 25% flux gain within the on-axis 45° cone may be achieved

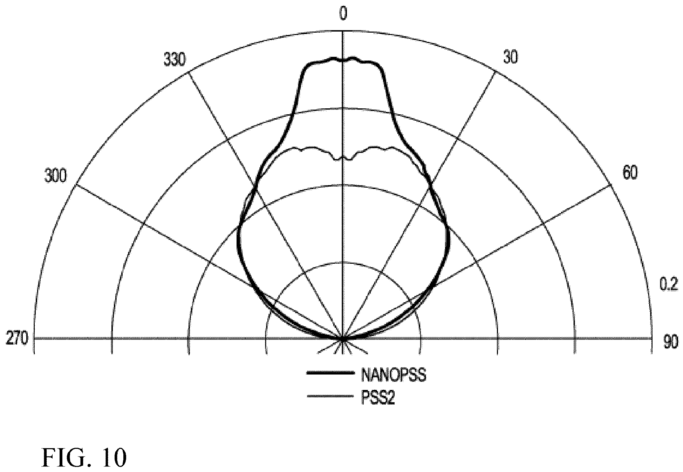

FIG. 10 illustrates angular far-field radiation of microPSS features and nanoPSS featuresof the microLED of FIG. 9, in accordance with some examples. As shown, LEDs with a nanoPSS provide a narrower and stronger emission compared with LEDs with a microPSS (PSS2).

In some embodiments, the angle θ is substantially the same for semiconductor layers 111, 112, and 114. In other embodiments, the angle θ is substantially the same for semiconductor layers 112 and 114, but different for semiconductor layer 111. Because the semiconductor layers are at different levels in the LED die, angle θ may be optimized to a different angle to reflect or scatter light more effectively to top surface 110.

In the example of FIG. 1, only three side walls of semiconductor layer 111 are covered with optical side coat material. One side wall of semiconductor layer 111 is left uncovered to allow n contact 141 to contact semiconductor layer 111. Leaving a side wall not covered with optical side coat simplifies the manufacturing process of the microLED. But all four side walls of semiconductor layer 111 may be covered with optical side coat material (not shown). In that case, the n contact 141 may be electrically connected to semiconductor layer 111 by use of a via or by optically transparent electrical contact on top surface 110 in a vertical die structure. The p contact 142 is electrically connected to semiconductor layer 114 by a metal via 143 through layer 130 and optical side coat 120. Metal via 143 is electrically connected to transparent conductive oxide (TCO) layer 115 which in turn contacts semiconductor layer 114.

In another embodiment, optical side coat 120 may include a distributed Bragg reflector (not shown). For example, the DBR may include an alternating sequence of layers of two different optical materials: one layer may be a thin film of a high refractive index material and another layer may be a thin film of low refractive index material. For example, the DBR may consist of alternating layers of titanium dioxide and silica. Light emitted from the side of the semiconductor layers 111, 112, and 114 will be reflected by the DBR. Due to the sloped side walls of the LED die, light reflected off the DBR will be directed towards top surface 110. If only a DBR is used, the separate dielectric layer 130 may not be needed. In some embodiments, the optical side coat includes a DBR and a metal layer, where the interface between the DBR and the metal layer forms an additional interface upon which light reflection may occur. If a metal layer is used, a separate dielectric layer 130 may be needed.

In another embodiment, optical side coat 120 may be a coating of silicone containing a high concentration of light scattering particles which may be titanium oxide (TiOx) particles. Light emitted from the side of the semiconductor layers 111, 112, and 114 will be scattered back into the semiconductor layer by the high concentration of TiOx particles. For example, optical side coat 120 may include between 40% and 60% by volume of TiOx particles. Due to the sloped side walls of the LED die, the scattered light will be direct towards top surface 110. If a silicone side coat is used, the separate dielectric layer 130 is not needed.

FIG. 2 shows a schematic cross-sectional view of an example LED die with scattering particles 210 on top surface 110 of the die. Scattering particles 210 in FIG. 2 are not drawn to scale and an LED light source will generally have more scattering particles than what is illustrated. Further, there may be more than one layer of scattering particles 210 (not shown). Scattering particles 210 may be TiOx particles. Scattering particles 210 may be held in place by thin-film layers 220, which may be deposited using chemical vapor deposition (CVD) or atomic layer deposition (ALD). Thin-film layers 220 may be transparent. Thin-film layers 220 are not drawn to scale in FIG. 2. Scattering particles 210 scatter and randomize light emitted from top surface 110, which creates a more Lambertian radiation pattern.

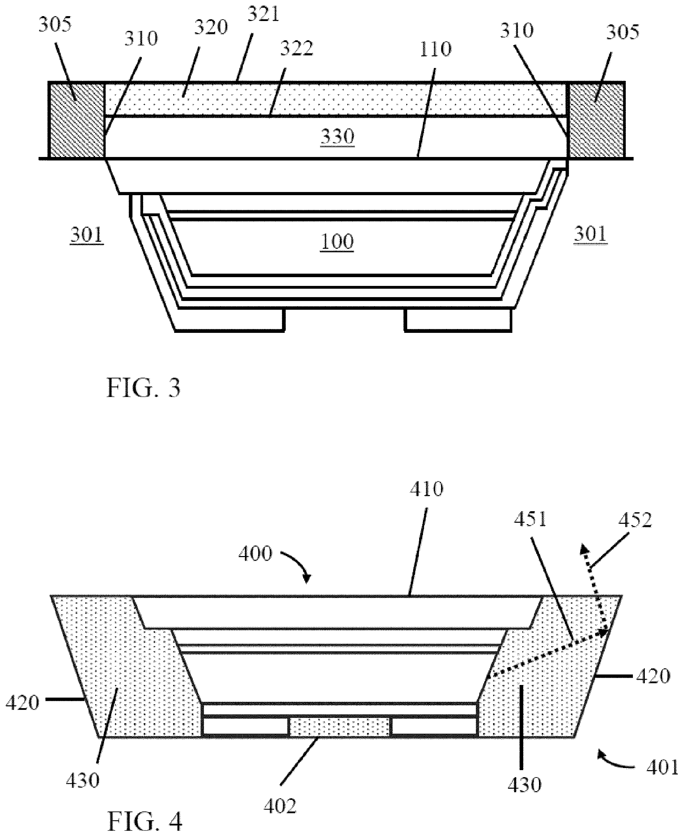

FIG. 3 shows a schematic cross-sectional view of an example LED die with an optical element 320. Optical element 320 may be made of glass, silicone, or any transparent material with a refractive index higher than the refractive index of air. Top surface 321 and bottom surface 322 of the optical element may be roughened or have an anti-reflective coating. The roughened surfaces of the optical element randomize light emission contributing to a more Lambertian radiation pattern. The anti-reflective coatings reduce specular reflections and therefore gives the light source a more Lambertian radiation pattern. Optical element 320 may for example have a curved top surface, a curved bottom surface, or both a curved top surface and a curved bottom surface (not shown). Curved top or bottom surfaces of the optical element may form a lens and may change the emitted radiation pattern of the LED die to a more Lambertian radiation pattern.

Optical element 320 is supported by hollow pedestal 305 which is mounted on the surface of material 301. Material 301 may be optical side coat material or any other material that would support pedestal 305. Interior side walls 310 of the pedestal are located at the perimeter of the top surface 110 of the LED die as shown in FIG. 3. Interior side walls 310, the top surface 110 of the LED die, and the bottom surface 322 of the optical element define a cavity 330 (thus making the pedestal hollow). Cavity 330 may be filled with air. FIG. 3 being a cross-sectional view only shows two side walls 310, but for a rectangular or square shaped LED die, two other side walls exist that are not shown - located in and out the plane of FIG. 3. Side walls 310 may be coated with reflective side coat, such as gold metal, silver metal, or a distributed Bragg reflector. The choice of reflective side coat depends on the wavelengths of light emitted from the LED die. By forming cavity 330, the pedestal creates three different surfaces (321, 322, 110) where radiation emission may be randomized and specular reflections may be reduced, i.e. by using an anti-reflective coating. Thus, optical element 320 with hollow pedestal 305 increases the emitted radiation pattern of the LED die to a more Lambertian radiation pattern.

FIG. 4 shows a schematic cross-sectional view of an example microLED die 400 mounted on the bottom surface 402 of cup structure 401. Die 400 does not have an optical side coat. Cup structure 401 is filled with fill 430. As shown in FIG. 4, fill 430 covers the sides of LED die 400 but not the top surface 410 of the LED die. In one example, fill 430 is a clear silicone fill and side walls 420 of the cup are covered with a reflective coating. The reflective coating may be a reflective metal such as silver or gold or may be a distributed Bragg reflector. Side walls 420 are sloped away from the interior of the cup so that light emitted from the sides of LED die (light ray 451) is reflected off side walls 420 and towards the top of and out of the cup (light ray 452). Light rays 451 and 452 are example light rays; many other reflected light rays not shown in FIG. 4 exist. In some embodiments, reflective coating, such as a high % TiOx coating (a coating with 40% and 60% by volume of TiOx particles), may also coat the inner surface of bottom surface 402 of the cup structure. In this embodiment, light may be scattered off the bottom surface of the cup towards the top of the cup.

In one example, side walls 420 of the cup may be roughened to randomize the angle of reflection off the side walls of the cup. The randomized angles of reflection contribute to a more Lambertian radiation pattern. In another example, fill 430 may include a small percentage of scattering particles, such as TiOx particles. The concentration of scattering particles in this example is between 2% and 20% by weight scattering particles. In this example, light emitted from the sides of the LED die will be randomly scattered by the scattering particles (not shown). Light not scattered towards the top of the cup may reflect off side walls 420 and after reflection be scattered towards the top of the cup. Bottom surface 402 of the cup may also in coated in reflective material so that light may reflect off the bottom surface of the cup. The random nature of the scattering contributes to a more Lambertian radiation pattern.

In another example, the percentage of scattering particles in fill 430 is high enough to prevent light from exiting the side of LED die 400. For example, fill 430 may be silicone between 40% and 60% by volume of TiOx particles. The high percentage scattering particle fill acts was an optical side coat and contributes to a more Lambertian radiation patterns similar to the examples of FIG. 1.

This disclosure is illustrative and not limiting. Further modifications will be apparent to one skilled in the art in light of this disclosure and are intended to fall within the scope of this appended claims.

## Claims

1. A LED light source comprising:
a microLED thin-film flip-chip die or a microLED die having a less than 30 micron thick sapphire layer, the die comprising:
a top surface,
a bottom surface,
semiconductor layers comprising an n-doped layer, a p-doped layer, and an active region; each semiconductor layer having sidewalls sloped at a greater than 20-degree angle away from a perpendicular to the bottom surface;
a reflective side coat covering the sidewalls of the semiconductor layers;
an n contact; and
a p contact, the n contact and the p contact on a same side of the die.

2. The LED light source of claim 1, wherein the reflective side coat comprises a dielectric layer and a metal layer.

3. The LED light source of claim 1, wherein the semiconductor layers comprise two or more n-doped layers, two or more p-doped layers, two or more active regions, and one or more tunnel junctions.

4. The LED light source of claim 2, comprising a second dielectric layer between the n contact and the metal layer of the side coat.

5. The LED light source of claim 1, wherein the reflective side coat comprises a distributed Bragg reflector.

6. The LED light source of claim 1, wherein the reflective side coat comprises scattering particles.

7. The LED light source of claim 1, the angle between the sidewalls of semiconductor layers and the perpendicular to the bottom surface is about 45 degrees.

8. The LED light source of claim 1, wherein the semiconductor layers comprises a semiconductor current spreading layer adjacent the top surface of the die, the current spreading layer comprising a first sidewall and a second sidewall, wherein the reflective side coat covers the first sidewall but not the second side wall of the current spreading layer.

9. The LED light source of claim 1, wherein the top surface of the die is roughened.

10. The LED light source of claim 1, comprising scattering particles in contact with the top surface of the die.

11. The LED light source of claim 10, comprising atomic layer deposition (ALD) layers on the scattering particles and the top surface of the die.

12. The LED light source of claim 1, wherein the semiconductor layers comprise two or more n-doped layers, two or more p-doped layers, two or more active regions, one or more tunnel junctions, and a transparent conductive oxide (TCO) layer.

13. The LED light source of claim 1, comprising a transparent cover over the top surface of the die; an air-filled cavity between the transparent cover and the top surface of the die; and a pedestal configured to hold the transparent cover above the top surface of the die.

14. The LED light source of claim 1, wherein the top surface of the die comprises a pattern with nanoscale features configured to narrow light emitted by the active region and center it on-axis.

15. The LED light source of claim 13, wherein the pedestal is coated with a coating to reflect light emitted by the microLED die.
